# EUROPEAN PATENT APPLICATION

(11) **EP 4 776 326 A1**
(43) Date of publication of application: **15.07.2026**
(21) Application number: 24863122.8
(22) Date of filing: 30.08.2024
(51) Int. Cl.: H01J 37/32, H01L 21/67

(54) **CHAMBER CLEANING METHOD**

(30) Priority: 05.09.2023 KR 20230117662; 29.08.2024 KR 20240116454
(71) Applicant: Jusung Engineering Co., Ltd., Gwangju-si, Gyeonggi-do 12773 (KR)
(72) Inventor: HWANG, Chul Joo, Yongin-si Gyeonggi-do 17094 (KR); KIM, Jae Ho, Yongin-si Gyeonggi-do 17094 (KR)
(74) Representative: AWA Sweden AB
(86) International application number: PCT/KR2024/012977
(87) International publication number: WO 2025/053541

(57) **Abstract**

The present invention provides a method of cleaning a chamber forming a perovskite compound, the method including a step of exposing an inner portion of the chamber to hydrogen (H)-containing gas plasma and a step of exposing the inner portion of the chamber to oxygen (O)-containing gas plasma, wherein the step of exposing the inner portion of the chamber to the oxygen (O)-containing gas plasma is performed after the step of exposing the inner portion of the chamber to the hydrogen (H)-containing gas plasma.

## Description

### [Technical Field]

The present invention relates to a method of cleaning a chamber.

### [Background Art]

Solar cells are a device which converts light energy into electrical energy by using properties of a semiconductor.

Solar cells have a PN junction structure where a positive (P)-type semiconductor is bonded to a negative (N)-type semiconductor. When sunlight is incident on a solar cell having such a structure, a hole and an electron are generated in the semiconductor by energy of the incident sunlight, and at this time, the hole (+) moves to the P-type semiconductor and the electron (-) moves to the N-type semiconductor, based on an electric field generated in a PN junction, and thus, an electric potential is generated, thereby generating power.

As described above, each of a hole (+) and an electron (-) generated from sunlight incident on a solar cell moves through a transparent conductive layer and an electrode included in the solar cell. The electrode may be provided in each of an upper surface and a lower surface of a solar cell substrate, or may be provided in one of the upper surface and the lower surface of the solar cell substrate, and a current may move based on the hole (+) and the electron (-) which have moved through each electrode.

In the related art, in manufacturing a solar cell by using a perovskite compound, in order to clean a chamber which has manufactured the solar cell after manufacturing the solar cell, the chamber has been cleaned by a wetting process after a process stops and the chamber is disassembled, and in order to manufacture a solar cell again, equipment has been disassembled and again reassembled by a chamber cleaning method for enhancing a yield rate of a process such as reassembling the chamber, causing a problem where a time of a total process increases as much time is consumed. Therefore, there is a problem where a time of a process increases, and due to this, the manufacturing cost increases.

### [Disclosure]

### [Technical Problem]

The present invention is devised to solve the above-described problem and is for providing a chamber cleaning method which may clean the inside of a chamber through an in-situ process without disassembling the chamber, and thus, may prevent an excessive time from being taken in cleaning the chamber.

### [Technical Solution]

To accomplish the above-described objects, the present invention provides a method of cleaning a chamber forming a perovskite compound, the method including a step of exposing an inner portion of the chamber to hydrogen (H)-containing gas plasma and a step of exposing the inner portion of the chamber to oxygen (O)-containing gas plasma, wherein the step of exposing the inner portion of the chamber to the oxygen (O)-containing gas plasma is performed after the step of exposing the inner portion of the chamber to the hydrogen (H)-containing gas plasma.

The present invention provides a chamber cleaning method in which the perovskite compound includes a compound of ABX₃ (where the A includes a monovalent organic positive ion of an amine-based compound or a monovalent organic positive ion of an amidine-based compound, the B includes a divalent positive ion, and the X includes at least one halogen compound).

The present invention provides a method of cleaning a chamber forming a perovskite compound, the method including a step of exposing an inner portion of the chamber to hydrogen (H)-containing gas plasma and a step of supplying a gas containing hexafluoroacetylacetone (Hhfac) into the chamber.

The present invention provides a chamber cleaning method in which the perovskite compound includes a compound of CABX₃ (where the A includes a monovalent organic positive ion of an amine-based compound or a monovalent organic positive ion of an amidine-based compound, the B includes a divalent positive ion, the C includes at least one alkali metal, and the X includes at least one halogen compound).

The present invention provides a chamber cleaning method in which the step of supplying the gas containing hexafluoroacetylacetone (Hhfac) includes a step of heating the chamber at 100 °C or more.

The present invention provides a chamber cleaning method in which the step of supplying the gas containing hexafluoroacetylacetone (Hhfac) includes a step of exposing the inner portion of the chamber to hexafluoroacetylacetone (Hhfac)-containing gas plasma.

The present invention provides a chamber cleaning method further including a step of exposing the inner portion of the chamber to oxygen (O)-containing gas plasma.

The present invention provides a chamber cleaning method in which a step of plasma-processing the oxygen (O)-containing gas to provide the oxygen (O)-containing gas plasma is performed after the step of exposing the inner portion of the chamber to the hydrogen (H)-containing gas plasma.

The present invention provides a chamber cleaning method in which the perovskite compound includes a compound of CBX₃ (where the B includes a divalent positive ion, the X includes at least one halogen compound, and the C includes at least one alkali metal).

The present invention provides a chamber cleaning method in which the step of supplying the gas containing hexafluoroacetylacetone (Hhfac) includes a step of heating the chamber at 100 °C or more.

The present invention provides a chamber cleaning method in which the step of supplying the gas containing hexafluoroacetylacetone (Hhfac) includes a step of exposing the inner portion of the chamber to hexafluoroacetylacetone (Hhfac)-containing gas plasma.

The present invention provides a method of cleaning a chamber forming a perovskite compound, the method including a step of exposing an inner portion of the chamber to hydrogen (H)-containing gas plasma and a step of exposing the inner portion of the chamber to oxygen (O)-containing gas plasma, wherein the step of exposing the inner portion of the chamber to the hydrogen (H)-containing gas plasma is performed after the step of exposing the inner portion of the chamber to the oxygen (O)-containing gas plasma.

The present invention provides a chamber cleaning method in which the perovskite compound includes a compound of ABX₃ (where the A includes a monovalent organic positive ion of an amine-based compound or a monovalent organic positive ion of an amidine-based compound, the B includes a divalent positive ion, and the X includes at least one halogen compound).

The present invention provides a chamber cleaning method further including a step of supplying a gas containing hexafluoroacetylacetone (Hhfac) into the chamber.

The present invention provides a chamber cleaning method in which the perovskite compound includes a compound of CABX₃ (where the A includes a monovalent organic positive ion of an amine-based compound or a monovalent organic positive ion of an amidine-based compound, the B includes a divalent positive ion, the C includes at least one alkali metal, and the X includes at least one halogen compound).

### [Advantageous Effect]

According to the present invention, the following effects may be realized.

According to an embodiment of the present invention, because it is not needed to separately perform a disassembling or reassembling step for cleaning a chamber, the delay of a total process may be prevented. That is, a process of cleaning the chamber may be performed through in-situ without separately disassembling the chamber, and thus, the productivity of a solar cell may be enhanced.

The effect of the present invention is not limited to the effect described above, but other effects not described herein will be clearly understood by those skilled in the art from descriptions below.

### [Description of Drawings]

FIG. 1 is a cross-sectional view of a solar cell according to an embodiment of the present invention.
FIG. 2A is a block diagram of a chamber cleaning method according to an embodiment of the present invention.
FIG. 2B is a block diagram of a chamber cleaning method according to another embodiment of the present invention.
FIG. 3 is a block diagram of a chamber cleaning method according to another embodiment of the present invention.
FIG. 4 is a block diagram of a chamber cleaning method according to another embodiment of the present invention.
FIG. 5 is a block diagram of a chamber cleaning method according to another embodiment of the present invention.
FIG. 6 is a block diagram of a chamber cleaning method according to another embodiment of the present invention.
FIG. 7A is a block diagram of a chamber cleaning method according to another embodiment of the present invention.
FIG. 7B is a block diagram of a chamber cleaning method according to another embodiment of the present invention.
FIG. 8A is a block diagram of a chamber cleaning method according to another embodiment of the present invention.
FIG. 8B is a block diagram of a chamber cleaning method according to another embodiment of the present invention.
FIG. 9 is a schematic diagram of a chamber which is a target of a chamber cleaning method according to an embodiment of the present invention.

### [Mode for Invention]

Advantages and features of the present invention, and implementation methods thereof will be clarified through the following embodiments described with reference to the accompanying drawings. The present invention may, however, be embodied in different forms and should not be construed as limited to the embodiments set forth herein. Rather, these embodiments are provided so that this invention will be thorough and complete, and will fully convey the scope of the present invention to those skilled in the art. Furthermore, the present invention is only defined by scopes of claims.

A shape, a size, a ratio, an angle, and a number disclosed in the drawings for describing embodiments of the present invention are merely an example, and thus, the present invention is not limited to the illustrated details. Like reference numerals refer to like elements throughout. In the following description, when the detailed description of the relevant known technology is determined to unnecessarily obscure the important point of the present invention, the detailed description will be omitted. In a case where 'comprise', 'have', and 'include' described in the present specification are used, another part may be added unless 'only~' is used. The terms of a singular form may include plural forms unless referred to the contrary.

In construing an element, the element is construed as including an error range although there is no explicit description.

In describing a position relationship, for example, when a position relation between two parts is described as 'on~', 'over~', 'under~', and 'next~', one or more other parts may be disposed between the two parts unless 'just' or 'direct' is used.

In describing a time relationship, for example, when the temporal order is described as 'after~', 'subsequent~', 'next~', and 'before~', a case which is not continuous may be included unless 'just' or 'direct' is used.

It will be understood that, although the terms "first", "second", etc. may be used herein to describe various elements, these elements should not be limited by these terms. These terms are only used to distinguish one element from another. For example, a first element could be termed a second element, and, similarly, a second element could be termed a first element, without departing from the scope of the present invention.

Features of various embodiments of the present invention may be partially or overall coupled to or combined with each other, and may be variously inter-operated with each other and driven technically as those skilled in the art can sufficiently understand. The embodiments of the present invention may be carried out independently from each other, or may be carried out together in co-dependent relationship.

Hereinafter, preferable embodiments of the present invention will be described in detail with reference to the accompanying drawings.

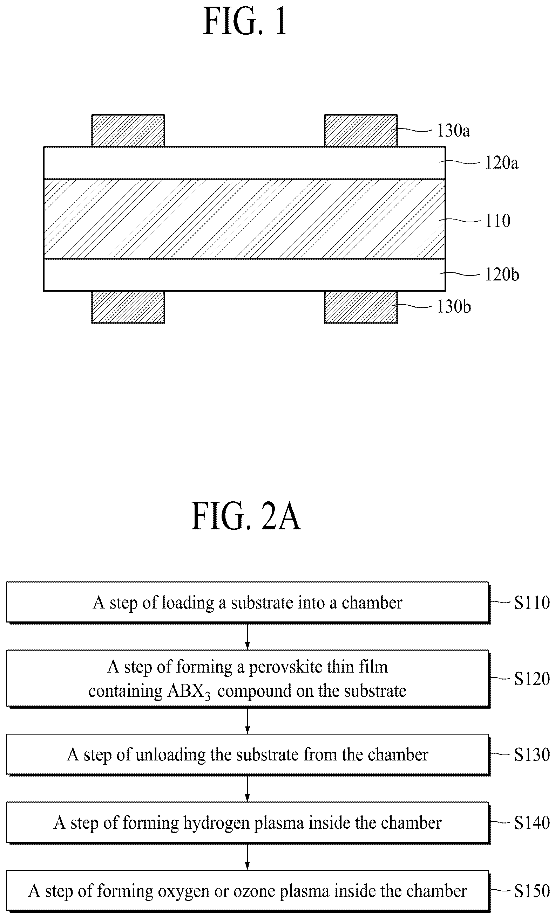

FIG. 1 is a cross-sectional view of a solar cell according to an embodiment of the present invention.

As seen in FIG. 1, the solar cell according to an embodiment of the present invention may include a solar cell 110, a first transparent conductive layer 120a, a second transparent conductive layer 120b, a first electrode 130a, and a second electrode 130b.

The solar cell 110 may include a perovskite compound. In this case, although not shown, the solar cell 110 including the perovskite compound may include a first conductive charge transfer layer, a light absorption layer provided on the first conductive charge transfer layer, and a second conductive charge transfer layer provided on the light absorption layer.

The first conductive charge transfer layer may include an electron transfer layer, and the second conductive charge transfer layer may include a hole transfer layer. Alternatively, the first conductive charge transfer layer may include a hole transfer layer, and the second conductive charge transfer layer may include an electron transfer layer.

In the ABX₃, the A may consist of a monovalent organic positive ion of the amine-based compound, may consist of a monovalent organic positive ion of the amidine-based compound, or may consist of a combination of the monovalent organic positive ion of the amine-based compound and the monovalent organic positive ion of the amidine-based compound. The A may have a structure where the monovalent organic positive ion of the amine-based compound is contained at an x ratio and the monovalent organic positive ion of the amidine-based compound is contained at a y ratio. In this case, each of x and y is greater than 0, and x+y=1.

In the ABX₃, the B consists of the divalent positive ion.

In the ABX₃, the X consists of at least one halogen compound.

The amine-based compound may be selected from among the group consisting of methylamine, ethylamine, and phenethylamine.

The amidine-based compound may consist of formamidine.

The organic metal compound including the divalent positive ion may include metal selected from among the group consisting of lead (Pb), tin (Sn), germanium (Ge), antimony (Sb), bismuth (Bi), and barium (Ba).

In detail, the organic metal compound including the divalent positive ion may consist of a compound represented by the following Chemical Formula 1:

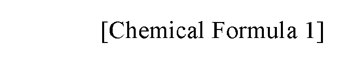

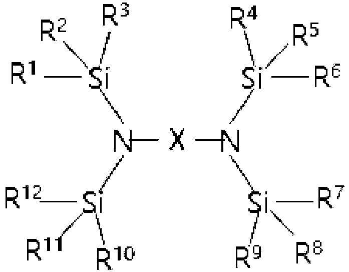

(In the Chemical Formula 1, each of R¹ to R¹² independently consists of hydrogen or an alkyl group, and the X is selected from among the group consisting of Pb, Sn, Ge, Sb, Bi, and Ba)

Alternatively, the organic metal compound including the divalent positive ion may be selected from among the group consisting of Pb(CH₃)₄, Pb(C₂H₅)₄, Pb(SCN)₂, (C₂H₅)₃PbOCH₂C(CH₃)₃, Pb(C₁₁H₁₉O₂)₂, Pb((CH₃)₃C-COCHCO-C(CH₃)₃)₂, Pb((C₆H₅)₂PCH₂P(C₆H₅)₂)₂, Pb(N(CH₃)₂C(CH₃)₂OH)₂, and C₁₂H₂₈N₂O₂Pb.

A light absorption rate, a band gap, carrier mobility, and material stability of a finally obtained perovskite compound may be adjusted based on the kind of organic metal compound including the divalent positive ion.

The hydrogen halide may be selected from among the group consisting of **HI,** HBr, Hf, and HCl. The band gap of the finally obtained perovskite compound may be adjusted based on the kind of hydrogen halide.

The amine-based compound, the amidine-based compound, the organic metal compound including the divalent positive ion, and the hydrogen halide consist of a material which vaporizes at a temperature within a range of a room temperature to 200 °C, and preferably, consist of a material which vaporizes at a temperature within a range of 50 °C to 150 °C. Therefore, a process of forming the compound of ABX₃ may be performed through a chemical vapor deposition (CVD) process or an atomic layer deposition (ALD) process at a temperature of 200 °C or less (preferably, 150 °C or less), and thus, an organic material of the compound of ABX₃ finally obtained may be prevented from being decomposed when performing the CVD or ALD process. Also, it is possible to apply plasma when performing the CVD or ALD process.

A perovskite compound according to another embodiment of the present invention may be obtained through a process of reacting at least one alkali metal-based compound, an organic metal compound including a divalent positive ion, and hydrogen halide with one another to manufacture a compound of CBX₃.

In the CBX₃, the C may consist of the at least one alkali metal.

In the CBX₃, the B consists of the divalent positive ion, and the X consists of at least one halogen compound.

The organic metal compound including the divalent positive ion and the hydrogen halide are the same as the above descriptions, and thus, their repeated descriptions are omitted.

The alkali metal-based compound may consist of a compound represented by the following Chemical Formula 2:

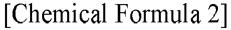

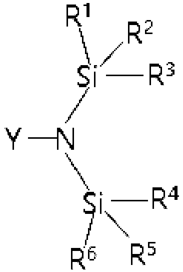

(In the Chemical Formula 2, each of R¹ to R⁶ independently consists of hydrogen or an alkyl group, and the Y is alkali metal)

A perovskite compound according to another embodiment of the present invention may be obtained through a process of reacting at least one compound selected from among an amine-based compound and an amidine-based compound, at least one alkali metal-based compound, an organic metal compound including a divalent positive ion, and hydrogen halide with one another to manufacture a compound of CABX₃.

In the CABX₃, the A may consist of a monovalent organic positive ion of the amine-based compound, may consist of a monovalent organic positive ion of the amidine-based compound, or may consist of a combination of the monovalent organic positive ion of the amine-based compound and the monovalent organic positive ion of the amidine-based compound.

In the CABX₃, the C may consist of the at least one alkali metal.

The CA may have a structure where the monovalent organic positive ion of the amine-based compound is contained at an x ratio, the monovalent organic positive ion of the amidine-based compound is contained at a y ratio, and a monovalent positive ion of the alkali metal is contained at a z ratio. In this case, each of x, y, and z is greater than 0, and x+y+z=1.

In the CABX₃, the B consists of the divalent positive ion, and the X consists of at least one halogen compound.

The amine-based compound, the amidine-based compound, the at least one alkali metal, the organic metal compound including the divalent positive ion, and the hydrogen halide are the same as the above descriptions, and thus, their repeated descriptions are omitted.

The first transparent conductive layer 120a may be provided on the solar cell 110. In detail, the first transparent conductive layer 120a is provided on an upper surface of the solar cell 110.

The first transparent conductive layer 120a is formed in the form of a thin film on the upper surface of the solar cell 110. The first transparent conductive layer 120a collects a carrier (for example, a hole) generated in the solar cell 110 and moves the collected carrier to the first electrode 130a.

The first transparent conductive layer 120a may consist of a transparent conductive material such as indium tin oxide (ITO), ZnOH, ZnO:B, ZnO:Al, SnO₂, or SnO₂:F, and ITO may be selected from among the materials.

The first transparent conductive layer 120a may be formed by a sputtering process, or may be formed by a chemical vaporization deposition (CVD) process.

The first electrode 130a is formed on the first transparent conductive layer 120a to configure a front surface of the solar cell. Accordingly, the first electrode 130 is patterned and formed in a certain shape so that sunlight is transmitted to the inside of the solar cell.

The first electrode 130a may consist of at least one metal selected from among the group consisting of silver (Ag), copper (Cu), aluminum (Al), molybdenum (Mo), and tungsten (W).

The first electrode 130a may be formed on the first transparent conductive layer 120a through a sputtering process, or may be formed through a plating process after a seed layer is formed. However, the present invention is not limited thereto, and the first electrode 130a may be formed by various processes based on a level of those of ordinary skill in the art.

The second transparent conductive layer 120b is formed in the form of a thin film on a lower surface of the solar cell 110.

The second transparent conductive layer 120b may be provided under the solar cell 110. The second transparent conductive layer 120b is formed in the form of a thin film on the lower surface of the solar cell 110. The second transparent conductive layer 120b collects a carrier (for example, a hole) generated in the solar cell 110 and moves the collected carrier to the second electrode 130b.

The second transparent conductive layer 120b may consist of a transparent conductive material such as indium tin oxide (ITO), ZnOH, ZnO:B, ZnO:Al, SnO₂, or SnO₂:F, and ITO may be selected from among the materials.

The second transparent conductive layer 120b may be formed by a sputtering process, or may be formed by a CVD process.

The second electrode 130b is formed on a lower surface of the second transparent conductive layer 120b. because the second electrode 130b is formed on a rearmost surface of the solar cell, the second electrode 130b may be formed on the entire lower surface of the second transparent conductive layer 120b, but as illustrated, the second electrode 130b may be patterned and formed so that reflected sunlight is incident through the lower surface of the solar cell.

The second electrode 130b may be patterned and formed on the lower surface of the second transparent conductive layer 120b. The second electrode 130b may consist of at least one metal selected from among the group consisting of Ag, Cu, Al, Mo, and W.

The second electrode 130b may be formed on the second transparent conductive layer 120b through a sputtering process, or may be formed through a plating process after the seed layer is formed. However, the present invention is not limited thereto, and the second electrode 130b may be formed by various processes based on a level of those of ordinary skill in the art.

Furthermore, in FIG. 1, the solar cell including the solar cell 110 is illustrated, but is not limited thereto and may be formed as a tandem-type solar cell where a buffer layer and a second solar cell are sequentially provided between the solar cell 110 and the first transparent conductive layer 120a. In this case, the second solar cell may include a crystalline solar cell, and the second solar cell may be formed by bonding different semiconductor layers to each other.

FIG. 2A is a block diagram of a chamber cleaning method according to an embodiment of the present invention.

As seen in FIG. 2A, the chamber cleaning method according to an embodiment of the present invention includes a step S110 of loading a substrate into a chamber, a step S120 of forming a perovskite thin film containing an ABX₃ compound on the substrate, a step S130 of unloading the substrate from the chamber, a step S140 of forming hydrogen (H₂) plasma in the chamber, and a step S150 of forming oxygen (O₂) or ozone (O₃) plasma in the chamber.

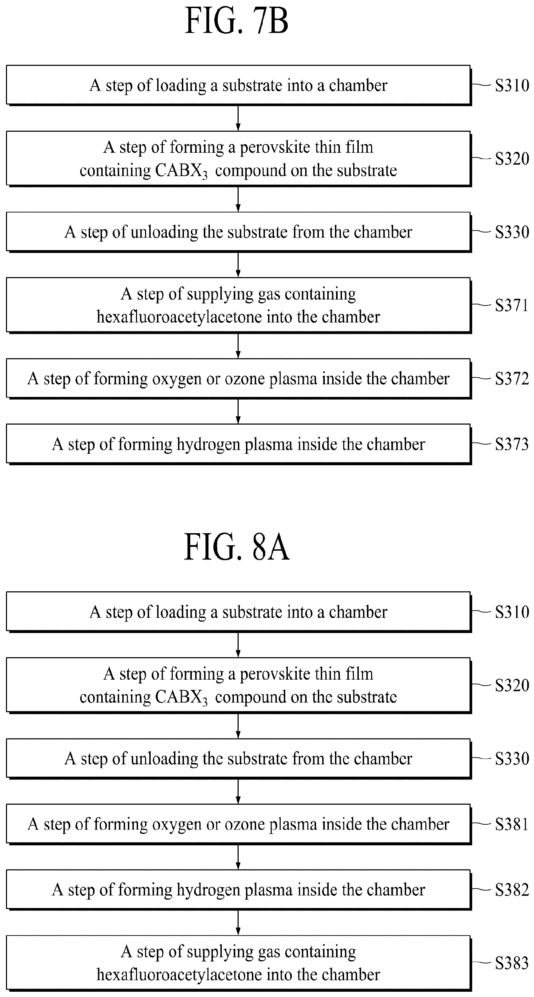

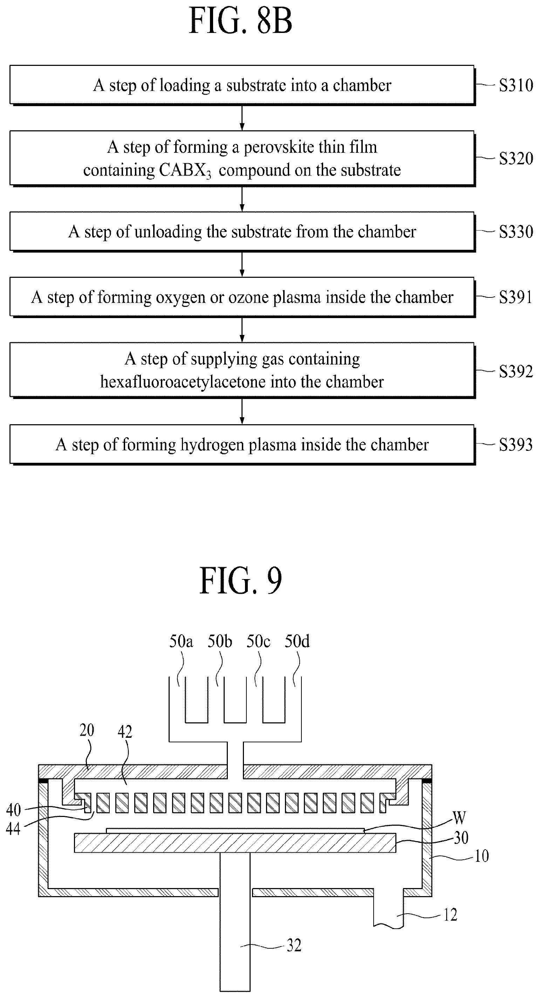

First, in the step S110 of loading the substrate into the chamber, a substrate for forming the perovskite solar cell 100 described above with reference to FIG. 1 may be loaded into a chamber (see 10 of FIG. 8) of a vacuum state. An opening/closing unit may be provided at one side of the chamber so that the substrate is loaded, and the inside and the outside of the chamber may be connected to or isolated from each other through the opening/closing unit. However, the present invention is not limited thereto.

Subsequently, in the step S120 of forming the perovskite thin film containing the ABX₃ compound on the substrate, the perovskite thin film containing the ABX₃ compound may be formed on the substrate included in the vacuum chamber.

The ABX₃ compound is the same as the description given above with reference to FIG. 1, and thus, its repeated description is omitted.

According to an embodiment of the present invention, the A of the ABX₃ compound may be one of an amine-based compound or an amidine-based compound, and for example, the A may contain methyl amine (CH₃NH₂) (MA), or the A may contain form amidine (NH₂CHNH) (FA).

Moreover, the B of the ABX₃ compound may be an organic metal compound including lead (Pb), and the X may include IₐBr_{b}. In this case, each of a and b may be greater than 0, and a+b=3.

According to an embodiment of the present invention, the ABX₃ compound may consist of, for example, one compound of MAPbI₃, FAPbI₃, MAPbBr₃, FAPbBr₃, MAFAPbI₃, MAFAPbBr₃, and MAFAPbBrₐI_{b}.

As formed in this manner, a perovskite thin film including one compound of MAPbI₃, FAPbI₃, MAPbBr₃, FAPbBr₃, MAFAPbI₃, MAFAPbBr₃, and MAFAPbBrₐI_{b} may be formed on the substrate.

In the step S130 of unloading the substrate from the chamber, the substrate where the perovskite thin film including one compound of MAPbI₃, FAPbI₃, MAPbBr₃, FAPbBr₃, MAFAPbI₃, MAFAPbBr₃, and MAFAPbBrₐI_{b} is formed may be unloaded from the inside of the vacuum chamber to the outside. In this case, the inside of the chamber from which the substrate has been removed may be isolated from the outside by the opening/closing unit.

In the step S140 of forming the hydrogen (H₂) plasma in the chamber, a material remaining after the perovskite thin film is formed in the vacuum chamber may be removed. In detail, by forming hydrogen (H)-containing plasma, the inside of the chamber may be exposed to the hydrogen (H)-containing gas plasma, and thus, at least one of an amine-based compound or an amidine-based compound, an organic metal compound including a divalent positive ion, and a halogen material remaining in an inner portion of the chamber or a wall surface of the chamber after the perovskite thin film is formed may be removed.

In detail, in a case where the hydrogen (H₂) plasma is formed in the vacuum chamber, some of the amine-based compound or the amidine-based compound remaining in the chamber may react with the hydrogen (H), and thus, hydrocarbon may be formed. For example, based on the hydrogen (H₂) plasma, some of methyl amine or form amidine remaining in the vacuum chamber may react with the hydrogen (H), and thus, hydrocarbon may be formed.

Furthermore, the other of the amine-based compound or the amidine-based compound may not react the hydrogen (H₂) plasma and may remain in the vacuum chamber. For example, the other of methyl amine or form amidine remaining in the vacuum chamber may not react the hydrogen (H₂) plasma and may remain in the vacuum chamber.

In this case, the amine-based compound or the amidine-based compound remaining without reacting with the hydrogen (H₂) plasma and the hydrocarbon formed by the hydrogen (H₂) plasma will be described in more detail in the below-described step S150 of forming oxygen (O₂) or ozone (O₃) plasma.

Furthermore, in a case where the hydrogen (H₂) plasma is formed in the vacuum chamber, the organic metal compound including the divalent positive ion remaining in the chamber may react with the hydrogen (H) and may thus be changed to a gas. For example, the organic metal compound including the divalent positive ion may be a lead (Pb)-containing material, and in this case, the lead (Pb)-containing organic metal compound may react with the hydrogen (H₂) plasma, and thus, plumbane (PbH₄) may be formed. In this case, a boiling point of the plumbane (PbH₄) may be -13 °C and may be in a gaseous state under an atmospheric pressure condition.

In a case where the hydrogen (H₂) plasma is formed in the vacuum chamber, the halogen material remaining in the chamber may react with the hydrogen (H) and may thus be changed to a gaseous state. For example, the halogen material may be a material containing bromine (Br) or iodine (I), and the halogen material may react with the hydrogen (H), and thus, hydrogen bromide (HBr) or hydrogen iodide (HI) may be formed. In this case, the hydrogen bromide (HBr) or the hydrogen iodide (HI) may be in a gaseous state under a room temperature and atmospheric pressure condition.

Subsequently, in the step S150 of forming the oxygen (O₂) or ozone (O₃) plasma in the chamber, a material remaining in the vacuum chamber after the perovskite thin film is formed may be removed. In detail, by forming oxygen (O)-containing plasma, the inside of the chamber may be exposed to the oxygen (O)-containing gas plasma, and thus, at least one of an amine-based compound or an amidine-based compound, remaining in the inner portion of the chamber or the wall surface of the chamber after the perovskite thin film is formed, and hydrocarbon formed through a reaction between hydrogen (H) and some of the amine-based compound or the amidine-based compound generated after the step S140 of forming the hydrogen (H₂) plasma in the chamber may be removed.

**In** more detail, in a case where the oxygen (O₂) or ozone (O₃) plasma is formed in the vacuum chamber, carbon dioxide (CO₂) may be formed by reacting the oxygen (O) with the amine-based compound or the amidine-based compound remaining after the step S140 of forming the hydrogen (H₂) plasma in the chamber. For example, based on the oxygen (O₂) or ozone (O₃) plasma, the other of methyl amine or form amidine remaining in the vacuum chamber may react with the oxygen (O) and may thus be changed to the form of carbon dioxide (CO₂), ammonia gas (NH₃), hydrogen (H₂), nitrogen (N₂), and water (H₂O).

Furthermore, the methyl amine or the form amidine reacting with hydrogen (H) in the step S140 of forming the hydrogen (H₂) plasma in the chamber may remain the vacuum chamber in the form of the hydrocarbon, and the hydrocarbon remaining in the vacuum chamber may react with oxygen (O) through the step S150 of forming the oxygen (O₂) or ozone (O₃) plasma in the chamber, and thus, carbon dioxide (CO₂) and water (H₂O) may be formed.

According to an embodiment of the present invention, impurities remaining in the vacuum chamber after the solar cell including the perovskite thin film containing the ABX₃ is formed may be removed in a gaseous state by the hydrogen (H₂) plasma and the oxygen (O₂) plasma, and thus, because it is not needed to separately perform a disassembling or reassembling step for cleaning the chamber, the delay of a total process may be prevented. That is, a process of cleaning the chamber may be performed through in-situ without separately disassembling the chamber, and thus, the productivity of a solar cell may be enhanced.

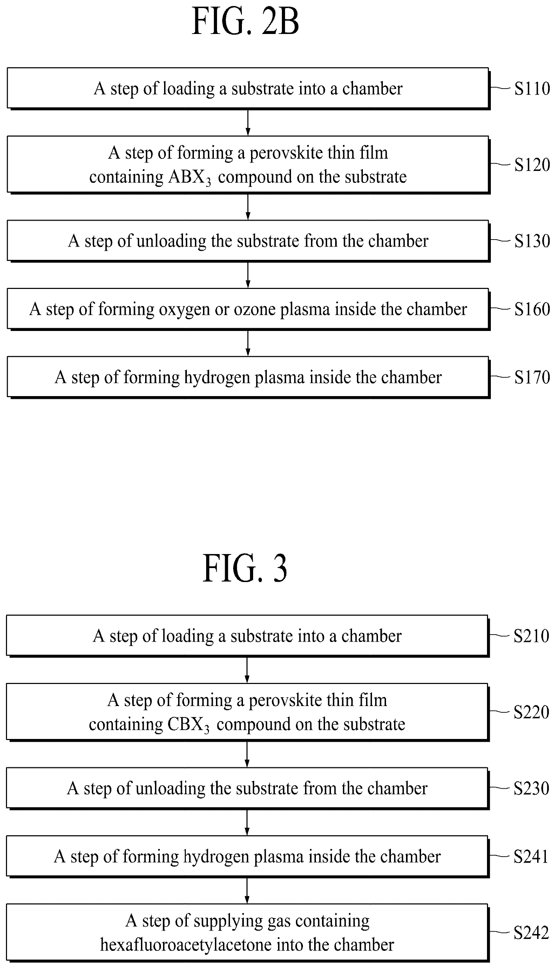

FIG. 2B is a block diagram of a chamber cleaning method according to another embodiment of the present invention. Except for the order of a step S160 of forming oxygen (O₂) or ozone (O₃) plasma in the chamber and a step S170 of forming hydrogen (H₂) plasma in the chamber, the embodiment of FIG. 2B is the same as the embodiment of FIG. 2A, and thus, different configurations will be mainly described.

As seen in FIG. 2B, the chamber cleaning method according to another embodiment of the present invention includes a step S110 of loading a substrate into a chamber, a step S120 of forming a perovskite thin film containing an ABX₃ compound on the substrate, a step S130 of unloading the substrate from the chamber, a step S160 of forming oxygen (O₂) or ozone (O₃) plasma in the chamber, and a step S170 of forming hydrogen (H₂) plasma in the chamber.

According to another embodiment of the present invention, impurities remaining in the vacuum chamber after the solar cell including the perovskite thin film containing the ABX₃ is formed may be removed in a gaseous state by the hydrogen (H₂) plasma and the oxygen (O₂) plasma, and thus, because it is not needed to separately perform a disassembling or reassembling step for cleaning the chamber, the delay of a total process may be prevented. That is, a process of cleaning the chamber may be performed through in-situ without separately disassembling the chamber, and thus, the productivity of a solar cell may be enhanced.

FIG. 3 is a block diagram of a chamber cleaning method according to another embodiment of the present invention.

As seen in FIG. 3, the chamber cleaning method according to an embodiment of the present invention includes a step S210 of loading a substrate into a chamber, a step S220 of forming a perovskite thin film containing a CBX₃ compound on the substrate, a step S230 of unloading the substrate from the chamber, a step S241 of forming hydrogen (H₂) plasma in the chamber, and a step S242 of supplying a gas containing hexafluoroacetylacetone (Hhfac) into the chamber. Also, the step S210 of loading the substrate into the chamber and the step S230 of unloading the substrate from the chamber are the same as the above descriptions of FIG. 2A, and thus, their repeated descriptions are omitted below.

In the step S220 of forming the perovskite thin film containing the CBX₃ compound on the substrate, the perovskite thin film containing the CBX₃ compound may be formed on the substrate provided in the vacuum chamber.

The CBX₃ compound is the same as the above description of FIG. 1, and thus, its repeated description is omitted.

According to an embodiment of the present invention, the C of the CBX₃ compound may consist of at least one alkali metal. In this case, the C may be, for example, a cesium (Cs) positive ion. The B of the CBX₃ compound may be an organic metal compound including lead (Pb), and moreover, the X may include IₐBr_{b}. In this case, each of a and b may be greater than 0, and a+b=3.

According to an embodiment of the present invention, the CBX₃ compound may consist of, for example, one compound of CsPbI₃, CsPbBr₃, and CsPbBrₐI_{b}.

As formed in this manner, a perovskite thin film including one compound of CsPbI₃, CsPbBr₃, and CsPbBrₐI_{b} may be formed on the substrate.

In the step S241 of forming the hydrogen (H₂) plasma in the chamber, a material remaining after the perovskite thin film is formed in the vacuum chamber may be removed. In detail, by forming hydrogen (H)-containing plasma, the inside of the chamber may be exposed to the hydrogen (H)-containing gas plasma, and thus, at least one of an organic metal compound including a divalent positive ion and a halogen material remaining in an inner portion of the chamber or a wall surface of the chamber after the perovskite thin film is formed may be removed.

In a case where the hydrogen (H₂) plasma is formed in the vacuum chamber, the organic metal compound including the divalent positive ion remaining in the chamber may react with the hydrogen (H) and may thus be changed to a gas. Subsequently, in a case where the hydrogen (H₂) plasma is formed in the vacuum chamber, the halogen material remaining in the chamber may react with the hydrogen (H) and may thus be changed to a gaseous state.

Furthermore, an example where the organic metal compound including the divalent positive ion and the halogen material are changed to a gas by the hydrogen (H₂) plasma is the same as FIG. 2A, and thus, its repeated description is omitted.

Subsequently, in the step S242 of supplying the gas containing hexafluoroacetylacetone (Hhfac) into the chamber, a material remaining after the perovskite thin film is formed in the vacuum chamber may be removed. In detail, by supplying the gas containing hexafluoroacetylacetone (Hhfac) into the chamber, at least one alkali metal remaining in an inner portion of the chamber or a wall surface of the chamber after the perovskite thin film is formed may be removed.

In detail, in a case where the gas containing hexafluoroacetylacetone (Hhfac) is supplied into the vacuum chamber, at least one alkali metal remaining in the chamber may react with the gas containing hexafluoroacetylacetone (Hhfac), and thus, may be removed in a gaseous state of metal hexafluoroacetylacetone (Mhfac) (where M denotes an alkali metal positive ion). For example, a cesium (Cs) positive ion remaining in the vacuum chamber may react with the hexafluoroacetylacetone (Hhfac) and may thus be changed to the form of cesium hexafluoroacetylacetone (Cs(hfac)). In this case, the cesium hexafluoroacetylacetone (Cs(hfac)) may be in a gaseous state under a room temperature and atmospheric pressure condition.

According to another embodiment of the present invention, in the step S242 of supplying the gas containing hexafluoroacetylacetone (Hhfac) into the chamber, the gas containing hexafluoroacetylacetone (Hhfac) may be supplied, and then, the inside of the chamber may be heated at a temperature of 100 °C or more. In this case, reactivity between the gas containing hexafluoroacetylacetone (Hhfac) and the alkali metal material may be good, and thus, the alkali metal material in the chamber may be easily removed.

Moreover, according to another embodiment of the present invention, in the step S242 of supplying the gas containing hexafluoroacetylacetone (Hhfac) into the chamber, plasma containing hexafluoroacetylacetone (Hhfac) may be formed, and thus, the inside of the chamber may be exposed to gas plasma containing hexafluoroacetylacetone (Hhfac). In this case, reactivity between the gas containing hexafluoroacetylacetone (Hhfac) and the alkali metal material may be good, and thus, the alkali metal material in the chamber may be more easily removed.

However, the present invention is not limited thereto, and in the step S242 of supplying the gas containing hexafluoroacetylacetone (Hhfac) into the chamber, the gas containing hexafluoroacetylacetone (Hhfac) may be supplied into the chamber without forming plasma or a temperature of less than 100 °C.

According to an embodiment of the present invention, impurities remaining in the vacuum chamber after the solar cell including the perovskite thin film containing the CBX₃ is formed may be removed in a gaseous state by the hydrogen (H₂) plasma and the hexafluoroacetylacetone (Hhfac), and thus, because it is not needed to separately perform a disassembling or reassembling step for cleaning the chamber, the delay of a total process may be prevented. That is, a process of cleaning the chamber may be performed through in-situ without separately disassembling the chamber, and thus, the productivity of a solar cell may be enhanced.

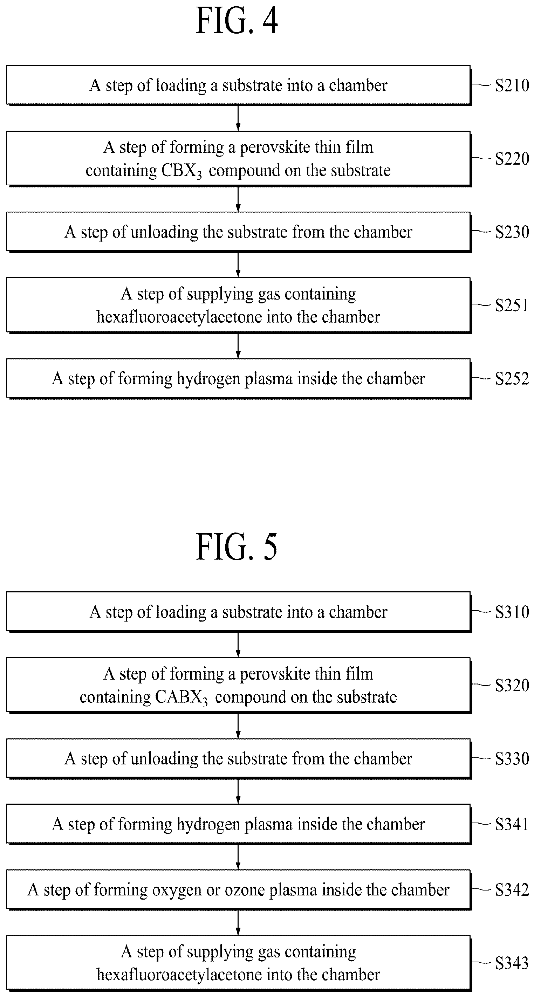

FIG. 4 is a block diagram of a chamber cleaning method according to another embodiment of the present invention. Except for the order of a step S251 of supplying a gas containing hexafluoroacetylacetone (Hhfac) into the chamber and a step S252 of forming hydrogen (H₂) plasma in the chamber, the embodiment of FIG. 4 is the same as the embodiment of FIG. 3, and thus, different configurations will be mainly described.

As seen in FIG. 4, the chamber cleaning method according to an embodiment of the present invention includes a step S210 of loading a substrate into a chamber, a step S220 of forming a perovskite thin film containing a CBX₃ compound on the substrate, a step S230 of unloading the substrate from the chamber, a step S251 of supplying a gas containing hexafluoroacetylacetone (Hhfac) into the chamber, and a step S252 of forming hydrogen (H₂) plasma in the chamber.

According to another embodiment of the present invention, the step S251 of supplying the gas containing hexafluoroacetylacetone (Hhfac) into the chamber may be performed prior to the step S252 of forming the hydrogen (H₂) plasma in the chamber.

Therefore, in a case where the gas containing hexafluoroacetylacetone (Hhfac) is supplied into the vacuum chamber, at least one alkali metal remaining in the chamber may react with the gas containing hexafluoroacetylacetone (Hhfac), and thus, may be removed in a gaseous state of metal hexafluoroacetylacetone (Mhfac) (where M denotes an alkali metal positive ion). Furthermore, an example where the alkali metal is changed to a gas by the gas containing hexafluoroacetylacetone (Hhfac) is the same as FIG. 3, and thus, its repeated description is omitted.

Subsequently, the step S252 of forming hydrogen (H₂) plasma in the chamber may be performed. In this case, based on the hydrogen (H₂) plasma, the organic metal compound including the divalent positive ion remaining in the chamber may react with the hydrogen (H) and may thus be changed to a gas, and the halogen material remaining in the chamber may react with the hydrogen (H) and may thus be changed to a gaseous state. Furthermore, an example where the organic metal compound including the divalent positive ion and the halogen material react with the hydrogen (H) and is thus changed to a gaseous state by the hydrogen (H₂) plasma is the same as the above description of FIG. 3, and thus, its repeated description is omitted.

According to an embodiment of the present invention, impurities remaining in the vacuum chamber after the solar cell including the perovskite thin film containing the CBX₃ is formed may be removed in a gaseous state by the hydrogen (H₂) plasma and the hexafluoroacetylacetone (Hhfac), and thus, because it is not needed to separately perform a disassembling or reassembling step for cleaning the chamber, the delay of a total process may be prevented. That is, a process of cleaning the chamber may be performed through in-situ without separately disassembling the chamber, and thus, the productivity of a solar cell may be enhanced.

FIG. 5 is a block diagram of a chamber cleaning method according to another embodiment of the present invention.

As seen in FIG. 5, the chamber cleaning method according to an embodiment of the present invention includes a step S310 of loading a substrate into a chamber, a step S320 of forming a perovskite thin film containing a CABX₃ compound on the substrate, a step S330 of unloading the substrate from the chamber, a step S341 of forming hydrogen (H₂) plasma in the chamber, a step S342 of forming oxygen (O₂) or ozone (O₃) plasma in the chamber, and a step S343 of supplying a gas containing hexafluoroacetylacetone (Hhfac) into the chamber. Also, the step S310 of loading the substrate into the chamber and the step S330 of unloading the substrate from the chamber are the same as the above descriptions of FIG. 2A, and thus, their repeated descriptions are omitted.

In the step S320 of forming the perovskite thin film containing the CABX₃ compound on the substrate, the perovskite thin film containing the CABX₃ compound may be formed on the substrate provided in the vacuum chamber.

The CABX₃ compound is the same as the above description of FIG. 1, and thus, its repeated description is omitted.

According to an embodiment of the present invention, the A of the CABX₃ compound may be one of an amine-based compound or an amidine-based compound, and for example, the A may contain form amidine (NH₂CHNH) (FA), and the C may consist of at least one alkali metal. In this case, the C may be, for example, a cesium (Cs) positive ion.

Moreover, the B of the CABX₃ compound may be an organic metal compound including lead (Pb), and the X may include IₐBr_{b}. In this case, each of a and b may be greater than or equal to 0, and a+b=3.

According to an embodiment of the present invention, the CABX₃ compound may consist of, for example, one compound of CsFAPbI₃, CsFAPbBr₃, and CsFAPbBrₐI_{b}.

As formed in this manner, a perovskite thin film including one compound of CsFAPbI₃, CsFAPbBr₃, and CsFAPbBrₐI_{b} may be formed on the substrate.

In the step S341 of forming the hydrogen (H₂) plasma in the chamber, a material remaining after the perovskite thin film is formed in the vacuum chamber may be removed. In detail, by forming hydrogen (H)-containing plasma, the inside of the chamber may be exposed to the hydrogen (H)-containing gas plasma, and thus, at least one of an amine-based compound or an amidine-based compound, an organic metal compound including a divalent positive ion, and a halogen material remaining in an inner portion of the chamber or a wall surface of the chamber after the perovskite thin film is formed may be removed.

Furthermore, a method of removing the amine-based compound or the amidine-based compound, the organic metal compound including the divalent positive ion, and the halogen material by using hydrogen (H₂) plasma is the same as a case of FIG. 2A described above, and thus, its repeated description is omitted.

According to another embodiment of the present disclosure, through the step S341 of forming the hydrogen (H₂) plasma in the chamber, some of the amine-based compound or the amidine-based compound remaining in the chamber may react with the hydrogen (H), and thus, hydrocarbon may be formed, and the other of the amine-based compound or the amidine-based compound remaining in the chamber may remain in the chamber and the organic metal compound including the divalent positive ion remaining in the chamber may react with the hydrogen (H) and may thus be changed to a gas, and the halogen material remaining in the chamber may react with the hydrogen (H) and may thus be changed to a gas.

Subsequently, in the step S342 of forming the oxygen (O₂) or ozone (O₃) plasma in the chamber, a material remaining in the vacuum chamber after the perovskite thin film is formed may be removed. In detail, by forming oxygen (O)-containing plasma, the inside of the chamber may be exposed to the oxygen (O)-containing gas plasma, and thus, at least one of an amine-based compound or an amidine-based compound, remaining in the inner portion of the chamber or the wall surface of the chamber after the perovskite thin film is formed, and at least one alkali metal and hydrocarbon formed through a reaction between hydrogen (H) and some of the amine-based compound or the amidine-based compound generated after the step S341 of forming the hydrogen (H₂) plasma in the chamber may be removed.

Furthermore, a method of forming oxygen (O₂) plasma in the chamber to remove the amine-based compound or the amidine-based compound and the hydrocarbon is the same as FIG. 2A, and thus, its repeated description is omitted.

According to another embodiment of the present invention, by forming plasma including oxygen (O) in the chamber, the plasma may react with some of at least one alkali metal remaining in the chamber, and thus, metal oxide may be formed. For example, the at least one alkali metal may be cesium (Cs), and the cesium (Cs) may react with the oxygen (O), and thus, cesium oxide (Cs₂O) may be formed. Also, the other cesium (Cs) which does not react with the oxygen (O) may intactly remain in the chamber.

Subsequently, in the step S343 of supplying the gas containing hexafluoroacetylacetone (Hhfac) into the chamber, a material remaining after the perovskite thin film is formed in the vacuum chamber may be removed. Furthermore, an example where the alkali metal is changed to a gas by the gas containing hexafluoroacetylacetone (Hhfac) is the same as FIG. 3, and thus, its repeated description is omitted.

According to another embodiment of the present invention, metal oxide formed through the step S342 of forming the oxygen (O₂) or ozone (O₃) plasma in the chamber may react with the gas containing hexafluoroacetylacetone (Hhfac) and may thus be removed. For example, cesium oxide (Cs₂O) remaining in the chamber may react with the hexafluoroacetylacetone (Hhfac), and thus, cesium hexafluoroacetylacetone (Cs(hfac)) may be formed. In this case, the cesium hexafluoroacetylacetone (Cs(hfac)) may be in a gaseous state.

According to an embodiment of the present invention, impurities remaining in the vacuum chamber after the solar cell including the perovskite thin film containing the CABX₃ is formed may be removed in a gaseous state by the hydrogen (H₂) plasma, the oxygen (O₂) plasma, and the hexafluoroacetylacetone (Hhfac), and thus, because it is not needed to separately perform a disassembling or reassembling step for cleaning the chamber, the delay of a total process may be prevented. That is, a process of cleaning the chamber may be performed through in-situ without separately disassembling the chamber, and thus, the productivity of a solar cell may be enhanced.

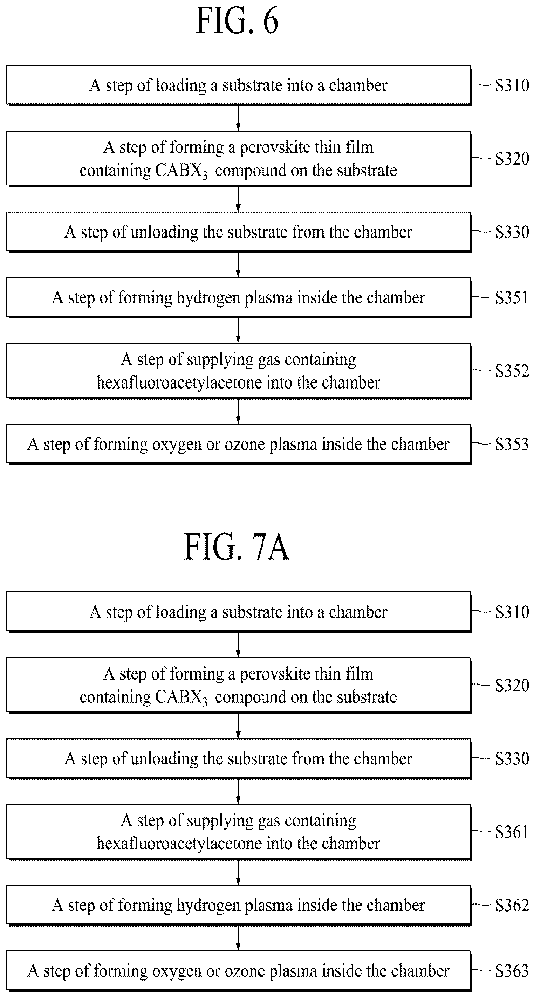

FIG. 6 is a block diagram of a chamber cleaning method according to another embodiment of the present invention.

Except for the order of a step S352 of supplying a gas containing hexafluoroacetylacetone (Hhfac) into the chamber and a step S353 of forming oxygen (O₂) or ozone (O₃) plasma in the chamber, the embodiment of FIG. 6 is the same as the embodiment of FIG. 5, and thus, different configurations will be mainly described.

As seen in FIG. 6, the chamber cleaning method according to an embodiment of the present invention includes a step S310 of loading a substrate into a chamber, a step S320 of forming a perovskite thin film containing a CABX₃ compound on the substrate, a step S330 of unloading the substrate from the chamber, a step S351 of forming hydrogen (H₂) plasma in the chamber, a step S352 of supplying a gas containing hexafluoroacetylacetone (Hhfac) into the chamber, and a step S353 of forming oxygen (O₂) or ozone (O₃) plasma in the chamber.

According to another embodiment of the present invention, the step S352 of supplying the gas containing hexafluoroacetylacetone (Hhfac) into the chamber may be performed prior to the step S353 of forming the oxygen (O₂) or ozone (O₃)plasma in the chamber.

Therefore, in the step S352 of supplying the gas containing hexafluoroacetylacetone (Hhfac) into the chamber, at least one alkali metal remaining in the chamber may react with the gas containing hexafluoroacetylacetone (Hhfac), and thus, may be removed in a gaseous state of metal hexafluoroacetylacetone (Mhfac) (where M denotes an alkali metal positive ion). For example, a cesium (Cs) positive ion remaining in the vacuum chamber may react with the hexafluoroacetylacetone (Hhfac) and may thus be changed to the form of cesium hexafluoroacetylacetone (Cs(hfac)). In this case, the cesium hexafluoroacetylacetone (Cs(hfac)) may be in a gaseous state.

Subsequently, the step S353 of forming the oxygen (O₂) plasma in the chamber may be performed. In this case, based on the oxygen (O₂) plasma, one of the amine-based compound or the amidine-based compound and hydrocarbon formed from some of the amine-based compound or the amidine-based compound after the step S351 of forming the hydrogen (H₂) plasma in the chamber may be removed. Furthermore, an example where the amine-based compound or the amidine-based compound and the hydrocarbon formed from the amine-based compound or the amidine-based compound react with oxygen (O) and is thus changed to a gaseous state by oxygen (O₂) plasma is the same as the above description of FIG. 4, and thus, its repeated description is omitted.

According to an embodiment of the present invention, impurities remaining in the vacuum chamber after the solar cell including the perovskite thin film containing the CABX₃ is formed may be removed in a gaseous state by the hydrogen (H₂) plasma, the oxygen (O₂) plasma, and the hexafluoroacetylacetone (Hhfac), and thus, because it is not needed to separately perform a disassembling or reassembling step for cleaning the chamber, the delay of a total process may be prevented. That is, a process of cleaning the chamber may be performed through in-situ without separately disassembling the chamber, and thus, the productivity of a solar cell may be enhanced.

FIG. 7A is a block diagram of a chamber cleaning method according to another embodiment of the present invention.

Except for the order of a step S361 of supplying a gas containing hexafluoroacetylacetone (Hhfac) into the chamber, a step S362 of forming hydrogen (H₂) plasma in the chamber, and a step S363 of forming oxygen (O₂) or ozone (O₃) plasma in the chamber, the embodiment of FIG. 7A is the same as the embodiment of FIG. 5, and thus, different configurations will be mainly described.

As seen in FIG. 7A, the chamber cleaning method according to an embodiment of the present invention includes a step S310 of loading a substrate into a chamber, a step S320 of forming a perovskite thin film containing a CABX₃ compound on the substrate, a step S330 of unloading the substrate from the chamber, a step S361 of supplying a gas containing hexafluoroacetylacetone (Hhfac) into the chamber, a step S362 of forming hydrogen (H₂) plasma in the chamber, and a step S363 of forming oxygen (O₂) or ozone (O₃) plasma in the chamber.

According to another embodiment of the present invention, the step S361 of supplying the gas containing hexafluoroacetylacetone (Hhfac) into the chamber may be performed prior to the step S362 of forming the hydrogen (H₂) plasma in the chamber and the step S363 of forming the oxygen (O₂) or ozone (O₃) plasma in the chamber

According to an embodiment of the present invention, impurities remaining in the vacuum chamber after the solar cell including the perovskite thin film containing the CABX₃ is formed may be removed in a gaseous state by the hydrogen (H₂) plasma, the oxygen (O₂) plasma, and the hexafluoroacetylacetone (Hhfac), and thus, because it is not needed to separately perform a disassembling or reassembling step for cleaning the chamber, the delay of a total process may be prevented. That is, a process of cleaning the chamber may be performed through in-situ without separately disassembling the chamber, and thus, the productivity of a solar cell may be enhanced.

FIG. 7B is a block diagram of a chamber cleaning method according to another embodiment of the present invention. Except for the order of a step S372 of forming oxygen (O₂) or ozone (O₃) plasma in the chamber and a step S373 of forming hydrogen (H₂) plasma in the chamber, the embodiment of FIG. 7B is the same as the embodiment of FIG. 7A, and thus, different configurations will be mainly described.

As seen in FIG. 7B, the chamber cleaning method according to an embodiment of the present invention includes a step S310 of loading a substrate into a chamber, a step S320 of forming a perovskite thin film containing a CABX₃ compound on the substrate, a step S330 of unloading the substrate from the chamber, a step S371 of supplying a gas containing hexafluoroacetylacetone (Hhfac) into the chamber, a step S372 of forming oxygen (O₂) or ozone (O₃) plasma in the chamber, and a step S373 of forming hydrogen (H₂) plasma in the chamber.

According to an embodiment of the present invention, impurities remaining in the vacuum chamber after the solar cell including the perovskite thin film containing the CABX₃ is formed may be removed in a gaseous state by the hydrogen (H₂) plasma, the oxygen (O₂) plasma, and the hexafluoroacetylacetone (Hhfac), and thus, because it is not needed to separately perform a disassembling or reassembling step for cleaning the chamber, the delay of a total process may be prevented. That is, a process of cleaning the chamber may be performed through in-situ without separately disassembling the chamber, and thus, the productivity of a solar cell may be enhanced.

FIG. 8A is a block diagram of a chamber cleaning method according to another embodiment of the present invention. Except for the order of a step S381 of forming oxygen (O₂) or ozone (O₃) plasma in the chamber, a step S382 of forming hydrogen (H₂) plasma in the chamber, and a step S383 of supplying a gas containing hexafluoroacetylacetone (Hhfac) into the chamber, the embodiment of FIG. 8A is the same as the embodiment of FIG. 7A, and thus, different configurations will be mainly described.

As seen in FIG. 8A, the chamber cleaning method according to an embodiment of the present invention includes a step S310 of loading a substrate into a chamber, a step S320 of forming a perovskite thin film containing a CABX₃ compound on the substrate, a step S330 of unloading the substrate from the chamber, a step S381 of forming oxygen (O₂) or ozone (O₃) plasma in the chamber, a step S382 of forming hydrogen (H₂) plasma in the chamber, and a step S383 of supplying a gas containing hexafluoroacetylacetone (Hhfac) into the chamber.

According to an embodiment of the present invention, impurities remaining in the vacuum chamber after the solar cell including the perovskite thin film containing the CABX₃ is formed may be removed in a gaseous state by the hydrogen (H₂) plasma, the oxygen (O₂) plasma, and the hexafluoroacetylacetone (Hhfac), and thus, because it is not needed to separately perform a disassembling or reassembling step for cleaning the chamber, the delay of a total process may be prevented. That is, a process of cleaning the chamber may be performed through in-situ without separately disassembling the chamber, and thus, the productivity of a solar cell may be enhanced.

FIG. 8B is a block diagram of a chamber cleaning method according to another embodiment of the present invention.

Except for the order of a step S392 of supplying a gas containing hexafluoroacetylacetone (Hhfac) into the chamber and a step S393 of forming hydrogen (H₂) plasma in the chamber, the embodiment of FIG. 8B is the same as the embodiment of FIG. 8A, and thus, different configurations will be mainly described.

As seen in FIG. 8B, the chamber cleaning method according to an embodiment of the present invention includes a step S310 of loading a substrate into a chamber, a step S320 of forming a perovskite thin film containing a CABX₃ compound on the substrate, a step S330 of unloading the substrate from the chamber, a step S391 of forming oxygen (O₂) or ozone (O₃) plasma in the chamber, a step S392 of supplying a gas containing hexafluoroacetylacetone (Hhfac) into the chamber, and a step S393 of forming hydrogen (H₂) plasma in the chamber.

According to an embodiment of the present invention, impurities remaining in the vacuum chamber after the solar cell including the perovskite thin film containing the CABX₃ is formed may be removed in a gaseous state by the hydrogen (H₂) plasma, the oxygen (O₂) plasma, and the hexafluoroacetylacetone (Hhfac), and thus, because it is not needed to separately perform a disassembling or reassembling step for cleaning the chamber, the delay of a total process may be prevented. That is, a process of cleaning the chamber may be performed through in-situ without separately disassembling the chamber, and thus, the productivity of a solar cell may be enhanced.

FIG. 9 is a schematic diagram of a chamber which is a target of a chamber cleaning method according to an embodiment of the present invention.

A solar cell deposition apparatus according to an embodiment of the present invention is an apparatus for forming a perovskite compound layer described above on a substrate W. The substrate W may consist of a semiconductor substrate.

As seen in FIG. 9, the solar cell deposition apparatus according to an embodiment of the present invention includes a chamber 10, a chamber lid 20, a supporter 30, a gas injection unit 40, and gas supply units 50a to 50d.

The chamber 10 provides a reaction space for a deposition process.

An exhaust port 12 for exhausting the reaction space may be provided in one bottom surface of the chamber 10.

The chamber lid 20 is installed at an upper portion of the chamber 10 to seal the reaction space.

The chamber lid 20 may be connected to the gas supply units 50a to 50d which supply a gas for a deposition process.

The supporter 30 is installed in the chamber 10 and supports the substrate W loaded from the outside. The supporter 30 may be connected to an elevation unit 32 and may be raised or lowered by the elevation unit 32.

The gas injection unit 40 may be installed under the chamber lid 20 so as to be opposite to the supporter 30. A gas diffusion space 42 where a gas supplied from the gas supply units 50a to 50d and passing through the chamber lid 20 is diffused may be formed between the gas injection unit 40 and the chamber lid 20.

The gas injection unit 40 may uniformly inject a gas, supplied from the gas supply units 50a to 50d, into an entire portion of the reaction space through a plurality of gas injection ports 44 connected to the gas diffusion space 42.

The gas supply units 50a to 50d may include a first gas supply unit 50a for supplying the alkali metal C of FIG. 1 described above, a second gas supply unit 50b for supplying an amine-based organic compound or an amidine-based organic compound A, a third gas supply unit 50c for supplying an organic metal compound B containing a divalent positive ion, and a fourth gas supply unit 50d for supplying a halogen material X. Each of the first to fourth gas supply units 50a to 50d may consist of an individual pipe, and individual pipes may be integrated into one and may be connected to the chamber lid 20. However, the present invention is not limited thereto, and each of the individual pipes may not be integrated into one and may be connected to the chamber lid 20.

Hereinabove, the embodiments of the present invention have been described in more detail with reference to the accompanying drawings, but the present invention is not limited to the embodiments and may be variously modified within a range which does not depart from the technical spirit of the present invention. Therefore, it should be understood that the embodiments described above are exemplary from every aspect and are not restrictive. It should be construed that the scope of the present invention is defined by the below-described claims instead of the detailed description, and the meanings and scope of the claims and all variations or modified forms inferred from their equivalent concepts are included in the scope of the present invention.

## Claims

1. A method of cleaning a chamber forming a perovskite compound, the method comprising:
a step of exposing an inner portion of the chamber to hydrogen (H)-containing gas plasma; and
a step of exposing the inner portion of the chamber to oxygen (O)-containing gas plasma,
wherein the step of exposing the inner portion of the chamber to the oxygen (O)-containing gas plasma is performed after the step of exposing the inner portion of the chamber to the hydrogen (H)-containing gas plasma.

2. The method of claim 1, wherein the perovskite compound comprises a compound of ABX₃ (where the A comprises a monovalent organic positive ion of an amine-based compound or a monovalent organic positive ion of an amidine-based compound, the B comprises a divalent positive ion, and the X comprises at least one halogen compound).

3. A method of cleaning a chamber forming a perovskite compound, the method comprising:
a step of exposing an inner portion of the chamber to hydrogen (H)-containing gas plasma; and
a step of supplying a gas containing hexafluoroacetylacetone (Hhfac) into the chamber.

4. The method of claim 3, wherein the perovskite compound comprises a compound of CABX₃ (where the A comprises a monovalent organic positive ion of an amine-based compound or a monovalent organic positive ion of an amidine-based compound, the B comprises a divalent positive ion, the C comprises at least one alkali metal, and the X comprises at least one halogen compound).

5. The method of claim 4, wherein the step of supplying the gas containing hexafluoroacetylacetone (Hhfac) comprises a step of heating the chamber at 100 °C or more.

6. The method of claim 4, wherein the step of supplying the gas containing hexafluoroacetylacetone (Hhfac) comprises a step of exposing the inner portion of the chamber to hexafluoroacetylacetone (Hhfac)-containing gas plasma.

7. The method of claim 4, further comprising a step of exposing the inner portion of the chamber to oxygen (O)-containing gas plasma.

8. The method of claim 7, wherein a step of plasma-processing a oxygen (O)-containing gas to provide the oxygen (O)-containing gas plasma is performed after the step of exposing the inner portion of the chamber to the hydrogen (H)-containing gas plasma.

9. The method of claim 3, wherein the perovskite compound comprises a compound of CBX₃ (where the B comprises a divalent positive ion, the X comprises at least one halogen compound, and the C comprises at least one alkali metal).

10. The method of claim 9, wherein the step of supplying the gas containing hexafluoroacetylacetone (Hhfac) comprises a step of heating the chamber at 100 °C or more.

11. The method of claim 9, wherein the step of supplying the gas containing hexafluoroacetylacetone (Hhfac) comprises a step of exposing the inner portion of the chamber to hexafluoroacetylacetone (Hhfac)-containing gas plasma.

12. A method of cleaning a chamber forming a perovskite compound, the method comprising:
a step of exposing an inner portion of the chamber to hydrogen (H)-containing gas plasma; and
a step of exposing the inner portion of the chamber to oxygen (O)-containing gas plasma,
wherein the step of exposing the inner portion of the chamber to the hydrogen (H)-containing gas plasma is performed after the step of exposing the inner portion of the chamber to the oxygen (O)-containing gas plasma.

13. The method of claim 12, wherein the perovskite compound comprises a compound of ABX₃ (where the A comprises a monovalent organic positive ion of an amine-based compound or a monovalent organic positive ion of an amidine-based compound, the B comprises a divalent positive ion, and the X comprises at least one halogen compound).

14. The method of claim 12, further comprising a step of supplying a gas containing hexafluoroacetylacetone (Hhfac) into the chamber.

15. The method of claim 14, wherein the perovskite compound comprises a compound of CABX₃ (where the A comprises a monovalent organic positive ion of an amine-based compound or a monovalent organic positive ion of an amidine-based compound, the B comprises a divalent positive ion, the C comprises at least one alkali metal, and the X comprises at least one halogen compound).
